# EUROPEAN PATENT APPLICATION

(11) **EP 1 748 485 A2**
(43) Date of publication of application: **31.01.2007**
(21) Application number: 06015785.6
(22) Date of filing: 28.07.2006
(51) Int. Cl.: H01L 23/48, H01L 23/00

(54) **Semiconductor device and manufacturing method of the same**

(30) Priority: 28.07.2005 JP 2005219588
(71) Applicant: SANYO ELECTRIC CO., LTD., Moriguchi City, Osaka (JP)
(72) Inventor: Suzuki, Akira, Ota-shi2Gunma 373-0841 (JP); Misaka, Elichi, Ora-gun Gunma 370-0514 (JP)
(74) Representative: Glawe, Delfs, Moll

(57) **Abstract**

The invention provides a semiconductor device that provides a high yield and has high reliability. A concave portion (5) is formed on a front surface of a semiconductor substrate (1), and a convex (7) portion is formed on an insulation substrate (6) (such as glass), corresponding to this concave portion (5). Then, the concave portion (5) and the convex portion (7) are engaged to bond the semiconductor substrate (1) and the insulation substrate (6) with an adhesion layer (8) interposed therebetween. A back surface of the semiconductor substrate is back-ground to expose the convex portion (7), and after then, processes such as forming a via hole, forming a penetrating electrode, forming a conductive terminal, and dicing are performed. At this time, the front surface and a sidewall of the semiconductor substrate (1) are covered (protected) with the insulation substrate. The convex portion (7) has a predetermined width and the dicing is performed almost on the center of the convex portion (7).

## Description

### Field of the Invention:

The invention relates to a semiconductor device with good workability and high reliability and a manufacturing method thereof.

### Description of the Related Art:

CSP (Chip Size Package) has received attention in recent years as a new three-dimensional packaging technology. The CSP means a small package having almost the same outside dimensions as those of a semiconductor die packaged in it.

Conventionally, BGA (ball grip array) type semiconductor devices have been known as a kind of CSP. In this BGA type semiconductor device, a plurality of ball-shaped conductive terminals made of metal such as solder is arrayed in a grid pattern on one surface of the package, and electrically connected with the semiconductor die mounted on the other side of the package.

When this BGA type semiconductor device is mounted on electronic equipment, the semiconductor die is electrically connected with an external circuit on a printed circuit board by bonding of the ball-shaped conductive terminals to wiring patterns on the printed circuit board.

Such a BGA type semiconductor device has advantages in providing a large number of conductive terminals and in reducing size over other CSP type semiconductor devices such as SOP (Small Outline Package) and QFP (Quad Flat Package), which have lead pins protruding from their sides. Therefore, the BGA type semiconductor device is broadly used as an image sensor chip for a digital camera incorporated into a mobile telephone, for example.

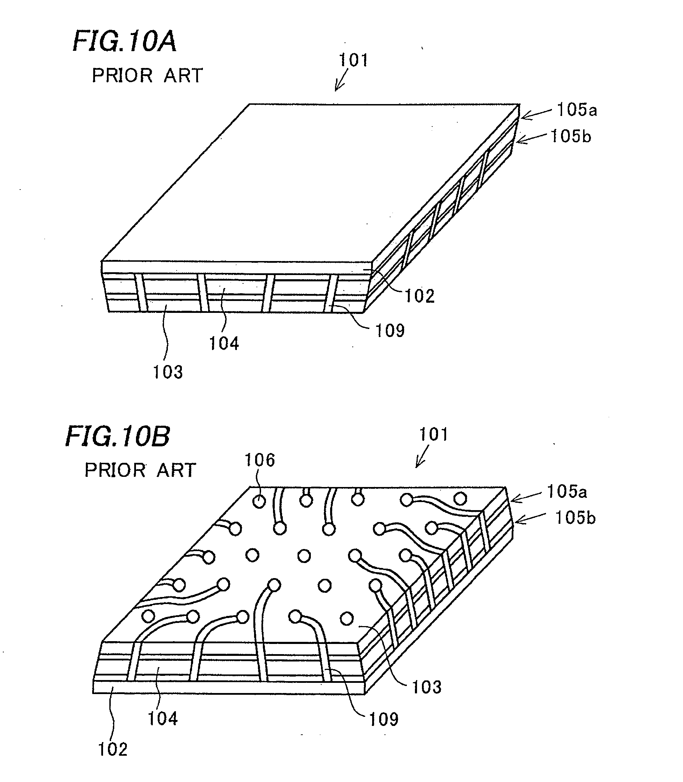

Figs. 10A and 10B show an outline structure of the conventional BGA type semiconductor device. Fig. 10A is an oblique perspective figure showing a front side of the BGA type semiconductor device. Fig. 10B is an oblique perspective figure showing a back side of the BGA type semiconductor device.

A semiconductor die 104 is sealed between a first glass substrate 102 and a second glass substrate 103 with epoxy resin layers 105a and 105b interposed therebetween in the BGA type semiconductor device 101. A plurality of conductive terminals 106 is arrayed in a grid pattern on a surface of the second glass substrate 103, that is, on the back surface of the BGA type semiconductor device 101. The conductive terminals 106 are connected to the semiconductor die 104 through a plurality of second wirings 109. The plurality of second wirings 109 is connected with aluminum wirings pulled out from inside of the semiconductor die 104, making each of the conductive terminals 106 electrically connected with the semiconductor die 104.

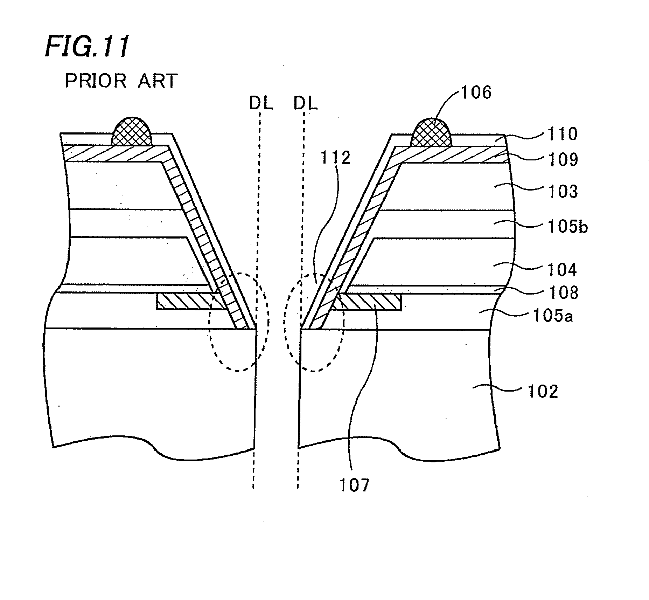

More detailed explanation on a cross-sectional structure of the BGA type semiconductor device 101 will be given hereafter referring to Fig. 11. Fig. 11 shows a cross-sectional view of the BGA type semiconductor devices 101 separated into individual dies along a dicing line.
A first wiring 107 is provided on an insulation film 108 formed on the front surface of the semiconductor die 104. The front surface of the semiconductor die 104 is bonded to the first glass substrate 102 with the resin layer 105a. The back surface of the semiconductor die 104 is bonded to the second glass substrate 103 with the resin layer 105b made of epoxy resin or the like.

One end of the first wiring 107 is connected to the second wiring 109. The second wiring 109 extends from the end of the first wiring 107 onto the front surface of the second glass substrate 103. The ball-shaped conductive terminal 106 is formed on the second wiring 109 extended onto the second glass substrate 103. A protection film 110 made of a solder resist or the like is formed on the front surface of the second wiring 109. The relevant technology is disclosed in Japanese Patent Application Publication Nos. 2002-512436 and 2003-309221.

However, the described conventional BGA type semiconductor device has a problem of reducing reliability of the semiconductor device due to, especially, difficulty in processing its die end 112. Concretely, for example, when the protection film 110 does not cover the die end 112, there is a problem of infiltration of corrosion materials such as moisture or chemicals into the wiring (the first wiring 107, the second wiring 109).

Furthermore, the protection film 110 is peeled off by a slight shift of a dicing line in a dicing process or impact occurring in the slight shift, causing a problem of exposing the wiring (the second wiring 109) or damaging elements such as the wiring (the first wiring 107) or the pad electrode formed inside. When a distance between the dicing line and the die end is set longer in order to prevent this problem, there is also a problem of reducing the number of dies in a wafer and increasing a die cost.

Furthermore, warping occurs at a contact point of the semiconductor die 104 and the support substrate (e.g. the first glass substrate 102) by temperature change of a temperature cycle (due to difference in thermal expansion coefficient), causing a problem of mechanical damage from the contact point or infiltration of corrosion materials therefrom.

Accordingly, with the conventional structure, stress, impact, or temperature change occurring to the semiconductor device causes the device failure, such as damage or deformation, thereby reducing its reliability. Such a problem also occurs to a so-called penetration type semiconductor device, which is described in Japanese Patent Application Publication No. 2003-309221. It is an object of this invention to provide a semiconductor device and manufacturing method thereof that lessen this drawback.

### SUMMARY OF THE INVENTION

The solution according to this invention resides in the features of the independent claims and preferably in those of the dependent claims.

The invention provides a semiconductor device that includes a semiconductor substrate having a front surface and a back surface. The semiconductor substrate has a via hole connecting the front and back surfaces. The device also includes a pad electrode disposed on the front surface so as to cover the via hole, a penetrating electrode disposed in the via hole and electrically connected with the pad electrode, a conductive terminal disposed on the back surface and electrically connected with the penetrating electrode, and an insulation substrate having a hole in which the semiconductor substrate is disposed.

The invention also provides a method of manufacturing a semiconductor device. The method includes providing a semiconductor wafer having a pad electrode disposed ori its front surface, forming a concave portion in the semiconductor wafer from the front surface toward a back surface of the semiconductor wafer, providing an insulation substrate, forming a convex portion in the insulation substrate, attaching the semiconductor wafer to the etched insulation substrate so that the convex portion engages with the concave portion, forming a via hole in the semiconductor wafer from the back surface to expose the pad electrode, forming a penetrating electrode in the via hole so as to be connected electrically with the pad electrode, and forming a conductive terminal on the back surface so as to be connected electrically with the penetrating electrode.

The invention further provides a method of manufacturing a semiconductor device. The method includes providing a semiconductor wafer, forming a concave portion in the semiconductor wafer, providing an insulation substrate, forming a convex portion patterned corresponding to the concave portion in the insulation substrate, attaching the semiconductor wafer to the insulation substrate so that the convex portion engages with the concave portion, and dicing only through the convex portion of the insulation substrate to produce a plurality of semiconductor devices from the semiconductor wafer.

### BRIEF DESCRIPTION OF THE DRAWINGS

Figs. 1A to 8 are a plan view and cross-sectional views for explaining a semiconductor device and its manufacturing method of the invention.
Fig. 9 is a plan view for explaining the semiconductor device and its manufacturing method of the invention.
Figs. 10A and 10B are perspective views for explaining a conventional semiconductor device.
Fig. 11 is a cross-sectional view for explaining the conventional semiconductor device.

### DETAILED DESCRIPTION OF THE INVENTION

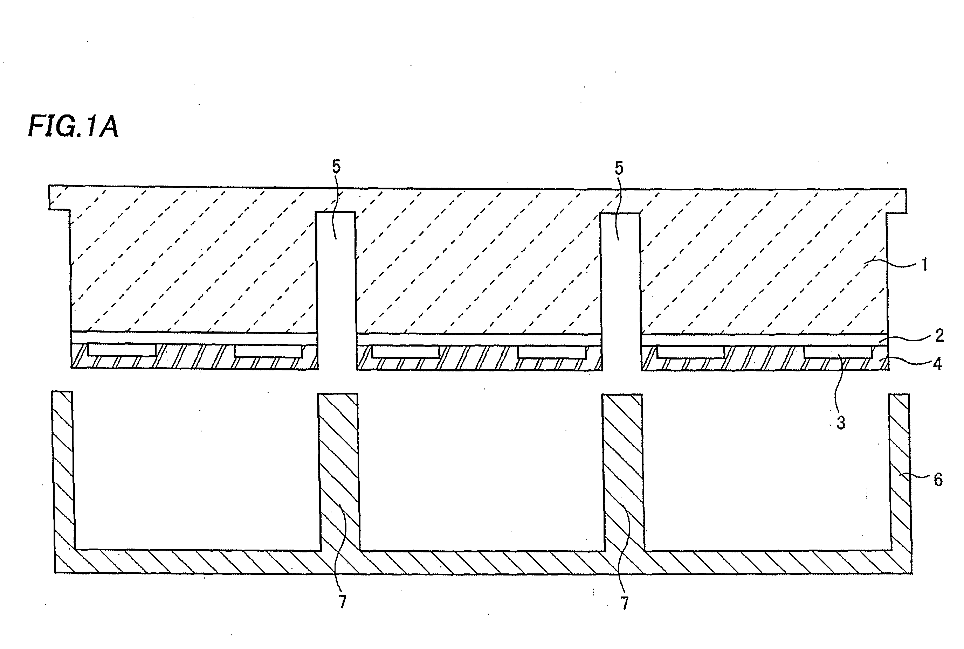

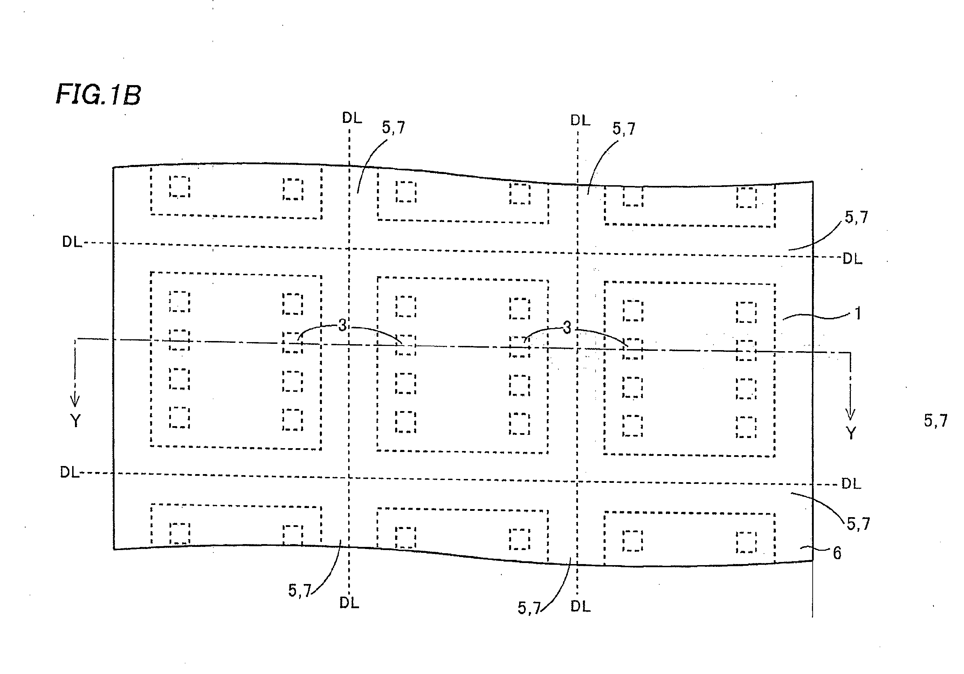

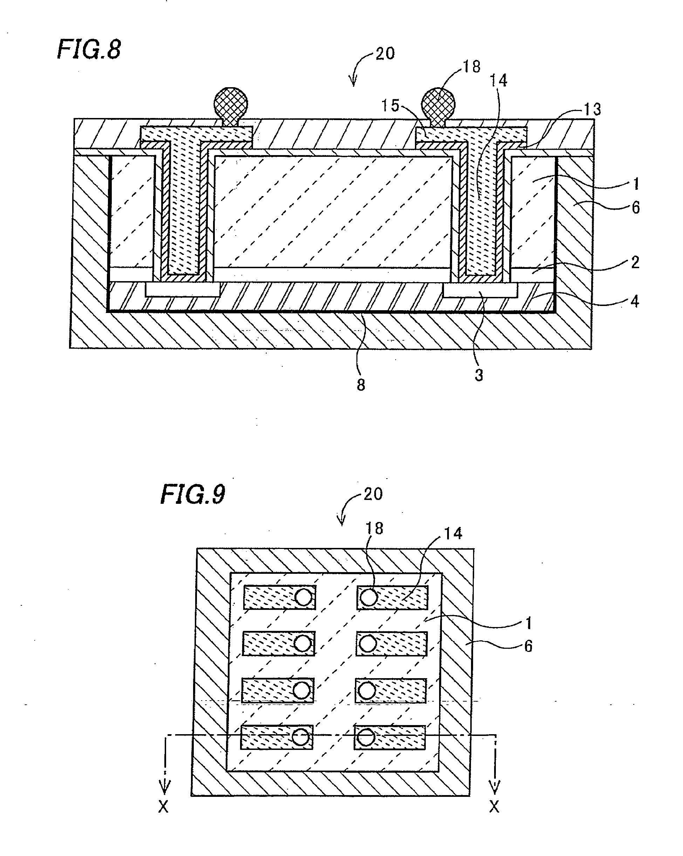

Next, an embodiment of the invention will be described in detail referring to figures. Figs. 1A to 8 are a plan view and cross-sectional views showing the process steps of the manufacturing method of this embodiment. Fig. 1B is a plan view of a device intermediate of this embodiment, and Fig. 1A is a schematic cross-sectional view of the structure of Fig. 1B along line Y-Y. Fig. 9 is a plan view of the semiconductor device of the embodiment showing its back side, and Fig. 8 is a cross-sectional view of Fig. 9 along line X-X. Elements such as a MOS transistor, a plurality of wirings, and a plug connecting the wirings, and an element separation made of a silicon oxide film are formed on a semiconductor substrate as appropriate although not shown in the figures. Although a large number of semiconductor devices 20 are formed at a time since following processes are performed by a wafer process, description will be given on the process of forming three semiconductor devices for convenience.

First, a first insulation film 2 (e.g. a silicon oxide film formed by a thermal oxidation method, a CVD method or the like) is formed on a front surface of a semiconductor substrate 1 made of silicon (Si) or the like to have a thickness, for example, 2 µm, as shown in Fig. 1A. Next, a metal layer made of aluminum (Al) or copper (Cu) serving as pad electrodes 3 is formed by a sputtering method, a plating method, or other deposition method, and this metal layer is etched using a mask (not shown) to form the pad electrodes 3 having a thickness, for example, 1 µm on the insulation film 2. The pad electrode 3 is an external connection electrode connected to an electronic device (not shown) on the semiconductor substrate 1.

Then, a passivation film 4, e.g. a silicon nitride film (SiN film) formed by a plasma CVD method, is formed to have a thickness of, for example, 2 µm so as to cover the pad electrodes 3. Then, predetermined concave portions 5 are formed in the semiconductor substrate 1 from its front surface toward its back surface. The concave portion 5 is a joint necessary for bonding the semiconductor substrate 1 to an insulation substrate 6 that is described below. In the plan view shown in Fig. 1B, the concave portions 5 are formed in positions corresponding to dicing lines DL of the semiconductor substrate 1. The concave portions 5 are formed by etching, laser beam irradiation, sandblasting, or the like. The depth of the concave portion 5 is about 200 µm and the width is about 40 µm, although not limited to these. The semiconductor substrate 1 formed with the predetermined concave portions 5 is thus formed. The sandblasting is a method of processing an object by spraying jets of particles such as alumina or silica on the object.

At the same time, the insulation substrate 6 made of glass, plastic, ceramic, quartz, or the like is prepared, and convex portions 7 are formed thereon corresponding to the concave portions 5 formed in the semiconductor substrate 1, as shown in Fig. 1A. The convex portion 7 is a joint necessary for bonding the insulation substrate 6 to the patterned semiconductor substrate 1 as described above. In the plan view shown in Fig. 1B, the convex portions 7 are formed in positions corresponding to dicing lines DL of the insulation substrate 6 in the same manner as the manner of forming the concave portions 5. These convex portions 7 are formed by etching, laser beam irradiation, sandblasting, or the like in the same manner as for forming the concave portions 5, in this embodiment. The insulation substrate 6 formed with the predetermined convex portions 7 is thus formed.

Although the concave portions 5 and the convex portions 7 form a straight shape in the figures, these may form a tapered shape.

As shown in Figs. 1B and 9, the dicing lines DL are set to form squares in the plan view of the dies as the end products in this embodiment. However, the dies as the end products are not necessarily form the squares, and can form other polygons (triangles or pentagons) or shapes having curved lines such as circles instead. The design of the concave portions 5 and the convex portions 7 in the plan view depends on the shapes of the dies as the end products in the plan view, that is, the design of the dicing lines.

Even if a slight separation is formed between the semiconductor substrate 1 and the supporting body 6 when the concave portions 5 and the convex portions 7 engage with each other, the separation is filled with the adhesion layer. Therefore, the shapes (heights or widths) of the concave portions 5 and the convex portions 7 do not necessarily match completely, and it is possible to form the convex portions 7 higher or lower than the concave portions 5, or narrower than the concave portions 5.

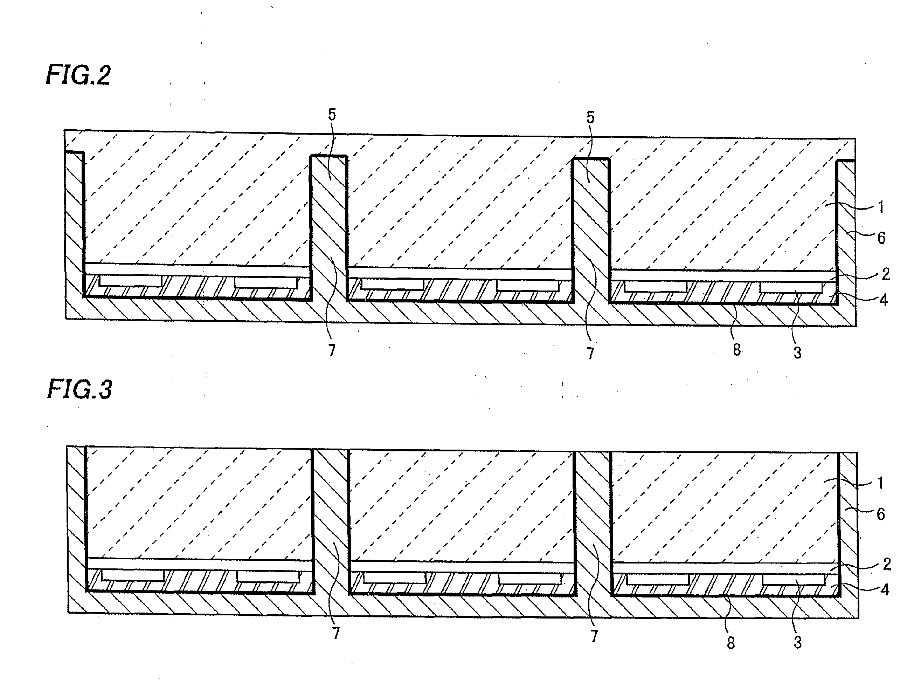

Next, an adhesive made of, for example, epoxy resin is coated on the front surface of the insulation substrate 6 including on the sidewall of the convex portion 7 (or on the front surface of the semiconductor substrate 1 including on the inner sidewall of the concave portion 5) by a spray coating method. Then, as shown in Fig. 2, the front surface of the semiconductor substrate 1 and the insulation substrate 6 are bonded to each other with this adhesive (adhesion layer 8) interposed therebetween. At this time, the concave portions 5 and the corresponding convex portions 7 are engaged.

An anodic bonding method may be used as the method of bonding the semiconductor substrate 1 and the insulation substrate 6. In this case, high electrostatic attraction occurs between the semiconductor substrate 1 and the insulation substrate 6, and both are bonded by chemical bond at an interface, which may be viewed as an adhesion layer 8. This method has such merits that highly precise bonding is possible because of solid-phase bonding or bonding without largely warping is possible because heating is performed only to necessary portions. It is noted that the adhesive and the anodic bonding method may be combined.

Next, the back surface of the semiconductor substrate 1 is etched, that is, a so-called back-grinding (BG) is performed, with this insulation substrate 6 being bonded, as shown in Fig. 3. It is preferable to perform this back-grinding at least until the convex portions 7 of the insulation substrate 6 are exposed from the back surface of the semiconductor substrate 1, for facilitating subsequent processes and manufacturing semiconductor devices with high reliability. This is because it is not necessary to leave the semiconductor substrate 1 on the convex portion 7 of the insulation substrate 6 in this embodiment.
Furthermore, this is also because dicing is performed easily when the semiconductor substrate 1 is thinned since the semiconductor dies can be separated by dicing the insulation substrate 6 only. Accordingly, the bottoms of the concave portions 5 are removed by this back-grinding in this embodiment.

In the subsequent processes, a strengthening measure and an anti-contamination measure for processes are taken by the insulation substrate 6 serving as a robust supporting body of the semiconductor substrate 1.

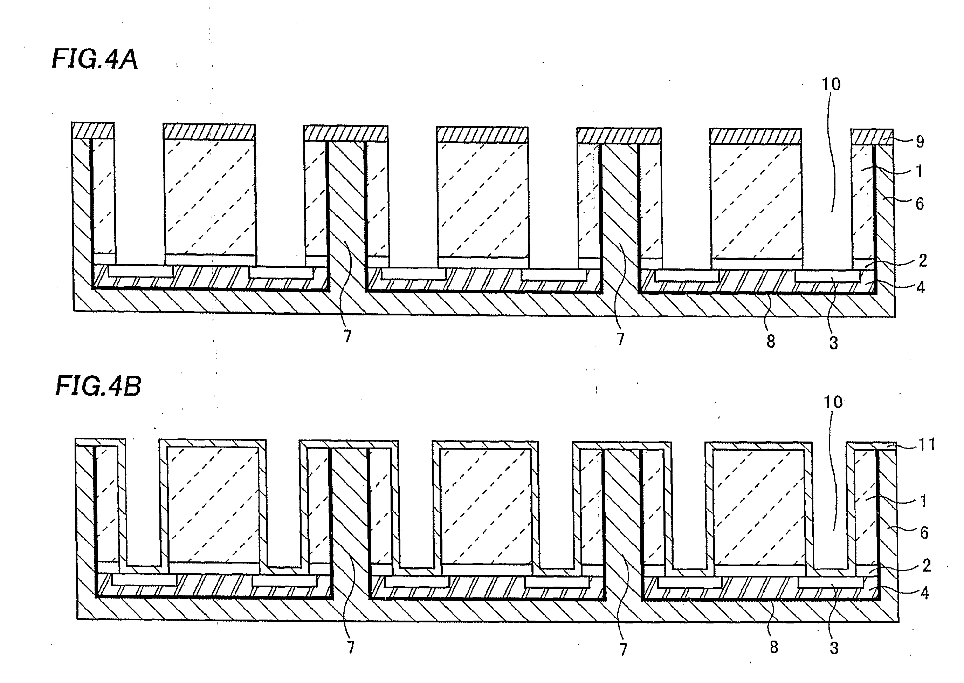

Next, a resist layer 9 is selectively formed on the back surface of semiconductor substrate 1. In other words, the resist layer 9 is formed to have openings on the back surface of the semiconductor substrate 1 in positions corresponding to the pad electrodes 3. Then, the semiconductor substrate 1 and the first insulation film 2 are selectively etched by, preferably, a dry-etching method using this resist layer 9 as a mask. Generally known CHF₃ or the like can be used as an etching gas for the dry-etching. The pad electrodes 3 are exposed by this etching, and via holes 10 are formed penetrating the semiconductor substrate 1 in the positions corresponding to the pad electrodes 3 from the back surface of the semiconductor substrate 1 to the surface of the pad electrodes 3, as shown in Fig. 4A.
Next, after the resist layer 9 is removed, a second insulation film 11 (e.g. a silicon nitride film or a silicon oxide film formed by a plasma CVD method) is formed on the whole back surface of the semiconductor substrate 1 including the via holes 10 to have a thickness of, for example, 1 µm, as shown in Fig. 4B.

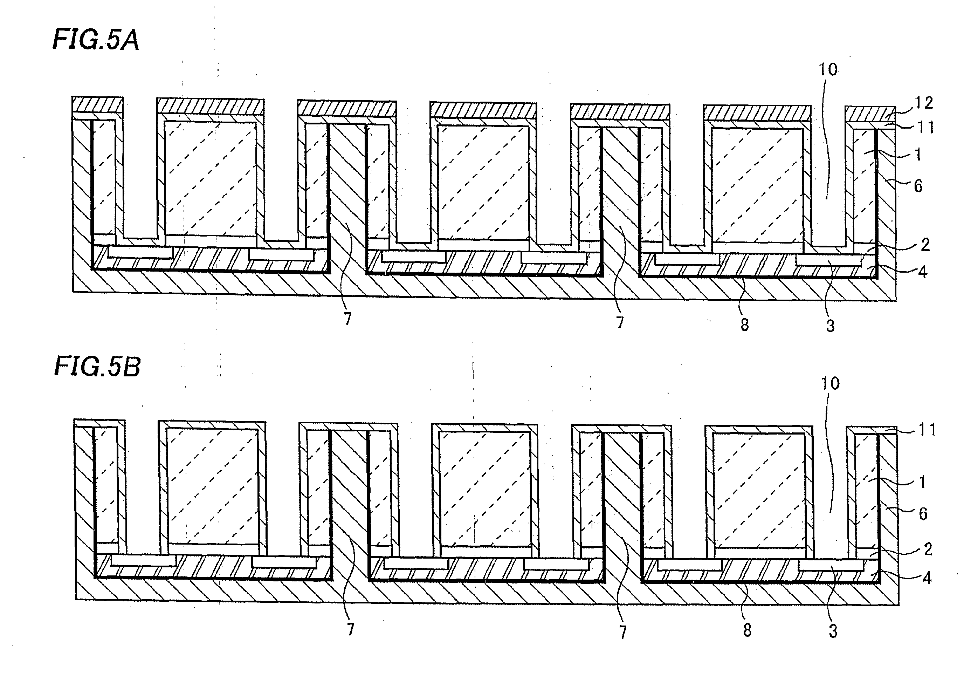

Next, a resist layer 12 is selectively formed on the second insulation film 11 except the via holes 10, as shown in Fig. 5A. Then, the second insulation film 11 (including the first insulation film 2 when it remains) on the bottom of the via hole 10 is removed by etching using the resist layer 12 as a mask. It is preferable that this etching is anisotropic ion etching, for example, but other etching techniques may be used. By this etching, as shown in Fig. 5B, the second insulation film 11 on the bottom is removed to expose the pad electrodes 3, while the second insulation film 11 on the back surface of the semiconductor substrate 1 and the sidewall of the via hole 10 remains. Then, the resist layer 12 is removed. It is possible to omit the process of etching and removing the first insulation film 2 in the process of Fig. 4A and to etch and remove the first insulation film 2 and the second insulation film 11 together in this process of etching and removing the second insulation film 11.

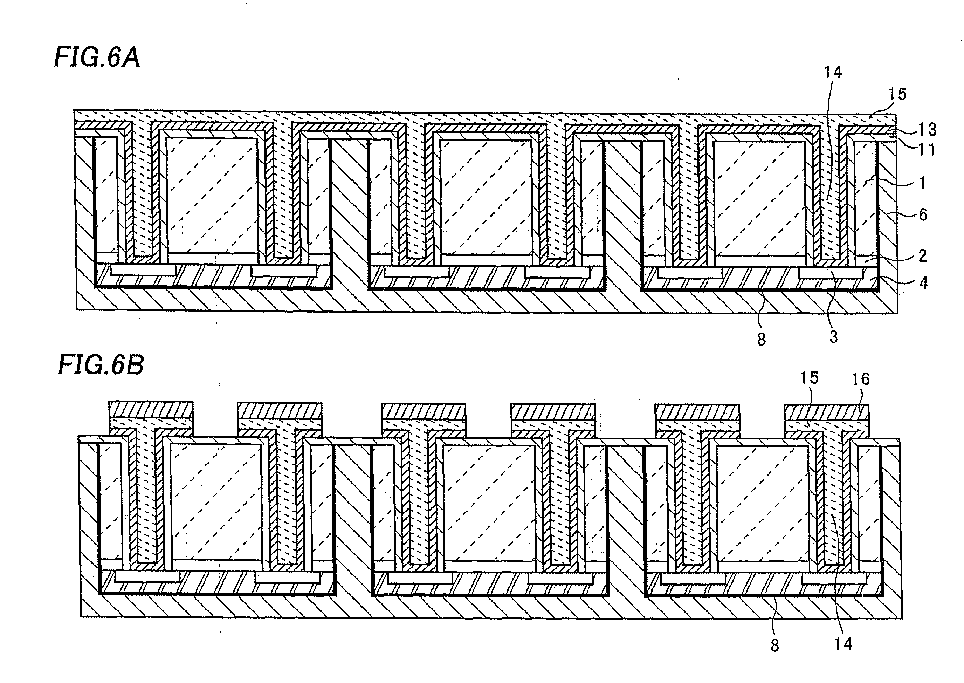

Next, a barrier metal layer 13 is formed on the second insulation film 11 on the back surface of the semiconductor substrate 1 and the pad electrodes 3 including in the via holes 10 as shown in Fig. 6A. Furthermore, a seed layer (not shown) is formed on the barrier metal layer 13. At this time, the barrier metal layer 13 is made of, for example, a metal layer such as a titanium tungsten (TiW) layer, a titanium nitride (TiN) layer, a tantalum nitride (TaN) layer, or the like. The seed layer (not shown) is to be an electrode for forming a penetrating electrode 14 and a wiring layer 15, that are described below, by plating, and made of, for example, metal such as copper (Cu). The barrier metal layer 13 is formed by, for example, a sputtering method, a CVD method, a PVD method, an electroless plating method, or other deposition methods.

Next, penetrating electrodes 14 made of copper (Cu) and a wiring layer 15 connected to the penetrating electrodes 14 are formed on the barrier metal layer 13 and the seed layer (not shown) including in the via hole 10 by, for example, an electroless plating method. The penetrating electrodes 14 and the wiring layer 15 are electrically connected to the pad electrodes 3 exposed at the bottom of the via holes 10 through the barrier metal layer 13 and the seed layer (not shown). It is possible that the penetrating electrodes 14 and the wiring layer 15 may be made of aluminum (Al) by a sputtering method or the like.

Next, a resist layer 16 for patterning the wiring layer 15 in a predetermined pattern is selectively formed on the wiring layer 15 on the back surface of the semiconductor substrate 1, as shown in Fig. 6B. This resist layer 16 is formed corresponding to the pattern of the wiring layer 15 (wiring) to be left.

Next, an unnecessary portion of the wiring layer 15 and the seed layer are removed by etching using the resist layer 16 as a mask. Then, the barrier metal layer 13 is removed by etching using the wiring layer 15 as a mask. The wiring layer 15 on the back surface of the semiconductor substrate 1 is patterned into a predetermined wiring pattern by this etching. Then, the resist layer 16 is removed.

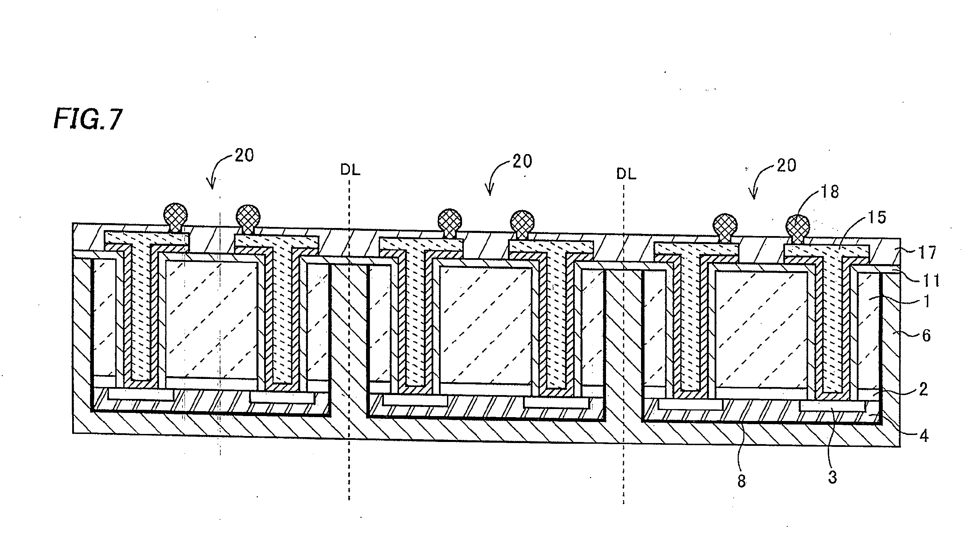

Next, a protection film 17 made of, for example, a resist material such as a solder resist is formed on the back surface of the semiconductor substrate 1 so as to cover this, as shown in Fig. 7. Openings are provided in the protection film 17 in predetermined positions on the wiring layer 15 (in conductive terminal formation regions). Then, ball-shaped conductive terminals 18 made of, for example, metal such as solder are formed on the wiring layer 15 exposed in the openings by a screen printing method. Individual BGA-type semiconductor devices 20 made of each layers are completed by the described processes. Since the described processes are performed by a wafer process, a large number of semiconductor devices 20 are formed in a wafer at the same time. By performing dicing along a dicing line DL that is a boundary of these semiconductor devices 20, the semiconductor devices 20 are cut and separated into each of the semiconductor devices 20 as shown in Fig. 8. At this time, the dicing line DL is set on the boundary of the semiconductor devices 20, that is, on the convex portion 7 of the insulation substrate 6. The insulation substrate 6 protects the semiconductor device 20 by buffering impact thereon. This reduces mechanical damage (peeling off or cracking of each layers of the semiconductor device 20) due to the dicing process, as has been a problem in the conventional art.

Furthermore, it is preferable to set the dicing line DL almost on the center of the convex portion 7 for protecting the semiconductor device 20 from the mechanical damage due to the dicing process and for enhancing the yield.

Since the dicing of this embodiment may mainly performed only to the insulation substrate 60 (e.g. glass) and not to the semiconductor layer (semiconductor substrate 1), the dicing control is easy.
Fig. 9 is a plan view of the semiconductor device 20 after the dicing of the embodiment showing its back side, and
Fig. 8 is a cross-sectional view of Fig. 9 along line X-X. It is noted that the protection film 17 is omitted in Fig. 9.

In the semiconductor device 20 of this embodiment, its front surface and sidewall are covered with the insulation substrate 6 and its back surface is covered with the protection film 17. Therefore, resistance to change in external environment (infiltration of corrosion materials, stress, or impact) and reliability in a manufacturing process and in use are largely enhanced compared with those of the conventional semiconductor device.

Although this embodiment is described on an application example to a BGA-type semiconductor device with a ball-shaped conductive terminal, the invention may be applied to a LGA (Land Grid Array)-type semiconductor device.

## Claims

1. A semiconductor device comprising:
a semiconductor substrate (1) comprising a front surface and a back surface, the semiconductor substrate (1) having a via hole (10) connecting the front and back surfaces;
a pad electrode (3) disposed on the front surface so as to cover the via hole (10);
a penetrating electrode (14) disposed in the via hole (10) and electrically connected with the pad electrode (3);
a conductive terminal (18) disposed on the back surface and electrically connected with the penetrating electrode (14);
and
an insulation substrate (6) having a hole in which the semiconductor substrate (1) is disposed.

2. The semiconductor device of claim 1, further comprising an adhesion layer (8) disposed in the hole and attaching the semiconductor substrate (1) to the insulation substrate (6).

3. The semiconductor device of claim 2, wherein the adhesion layer (8) comprises an adhesive.

4. The semiconductor device according to any of claims 1 to 3, wherein the insulation substrate (6) comprises a glass, a plastic, a ceramic or quartz.

5. The semiconductor device according to any of claims 1 to 4, further comprising a protection film (17) covering the semiconductor substrate (1) disposed in the hole so that the conductive terminal (18) protrudes from the protection film (17).

6. A method of manufacturing a semiconductor device, comprising:
providing a semiconductor wafer comprising a pad electrode (3) disposed on a front surface thereof;
forming a concave portion (5) in the semiconductor wafer from the front surface toward a back surface of the semiconductor wafer;
providing an insulation substrate (6);
shaping the insulation substrate (6) to have a convex portion (7);
attaching the semiconductor wafer to the insulation substrate (6) so that the convex portion (7) engages with the concave portion (5);
forming a via hole (10) in the semiconductor wafer from the back surface to expose the pad electrode (3);
forming a penetrating electrode (14) in the via hole (10) so as to be connected electrically with the pad electrode (3); and
forming a conductive terminal (18) on the back surface so as to be connected electrically with the penetrating electrode (14).

7. The method of claim 6, wherein the attaching of the semiconductor wafer and the insulation substrate (6) comprises providing an adhesive layer (8) between the substrate (6) and the wafer.

8. The method of claim 6, wherein the attaching of the semiconductor wafer and the insulation substrate (6) comprises an anodic bonding between the substrate (6) and the wafer.

9. The method according to any of claims 6 to 8, further comprising dicing through the convex portion (7) to produce an individual semiconductor device after the formation of the conductive terminal (18).

10. The method of claim 9, wherein no part of the semiconductor wafer is diced when the individual semiconductor device is produced by the dicing.

11. The method according to any of claims 6 to 10, further comprising etching the back surface of the semiconductor wafer to expose the convex portion (7) of the insulation substrate (6) attached to the semiconductor wafer.

12. A method of manufacturing a semiconductor device, comprising:
providing a semiconductor wafer;
forming a patterned concave portion (5) in the semiconductor wafer;
providing an insulation substrate (6);
shaping the insulation substrate (6) to have a convex portion (7) patterned corresponding to the concave portion (5);
attaching the semiconductor wafer to the insulation substrate (6) so that the patterned convex portion (7) engages with the patterned concave portion (5); and
dicing only through the patterned convex portion (7) of the insulation substrate (6) to produce a plurality of semiconductor devices from the semiconductor wafer.
